# EUROPÄISCHE PATENTANMELDUNG

(11) **EP 0 908 950 A2**
(43) Veröffentlichungstag der Anmeldung: **14.04.1999**
(21) Anmeldenummer: 98114226.8
(22) Anmeldetag: 29.07.1998
(51) Int. Cl.: H01L 23/522, H01L 27/02

(54) **Integrierte Schaltung**

(30) Priorität: 20.08.1997 DE 19736197
(71) Anmelder: SIEMENS AKTIENGESELLSCHAFT, 80333 München (DE)
(72) Erfinder: Ehben, Thomas, 81379 München (DE)

(57) **Zusammenfassung**

Es wird eine integrierte Schaltung mit Kondensatoren zur Glattung der Versorgungsspannung beschrieben. Die beschriebene integrierte Schaltung zeichnet sich dadurch aus, daß die Kondensatoren (11, 21; 12, 31) unterhalb der Versorgungsbahnen (1, 2), über welche die integrierte Schaltung mit der Versorgungsspannung versorgt wird, angeordnet sind. Dadurch kann die integrierte Schaltung auf einer minimalen Fläche untergebracht werden.

## Beschreibung

Die vorliegende Erfindung betrifft eine integrierte Schaltung gemaß dem Oberbegriff des Patentanspruchs 1, d.h. eine integrierte Schaltung mit Kondensatoren zur Glättung der Versorgungsspannung.

Integrierte Schaltungen sind in einer Vielzahl von Ausführungsformen bekannt und bedürfen keiner näheren Erläuterung. Die Glättung der Versorgungsspannung von integrierten Schaltungen durch Kondensatoren erweist sich als vorteilhaft, weil die betreffenden integrierten Schaltungen dadurch störungsfrei arbeiten können und eine verringerte elektromagnetische Emission aufweisen; die Integration der zur Glättung vorgesehenen Kondensatoren in die integrierte Schaltung ermöglicht eine besonders wirkungsvolle Glättung. Andererseits beanspruchen in integrierten Schaltungen vorgesehene Kondensatoren relativ viel Fläche auf dem die integrierte Schaltung enthaltenden Chip, wodurch Kondensatoren enthaltende integrierte Schaltung relativ groß und damit auch teuer, fehleranfällig und unhandlich sind.

Der vorliegenden Erfindung liegt daher die Aufgabe zugrunde, die integrierte Schaltung gemäß dem Oberbegriff des Patentanspruchs 1 derart weiterzubilden, daß diese auf einer möglichst kleinen Fläche unterbringbar ist.

Diese Aufgabe wird erfindungsgemäß durch die im kennzeichnenden Teil des Patentanspruchs 1 beanspruchten Merkmale gelöst.

Demnach ist vorgesehen, daß die Kondensatoren unterhalb der Versorgungsbahnen, über welche die integrierte Schaltung mit der Versorgungsspannung versorgt wird, angeordnet sind.

Da die Bereiche unter den Versorgungsbahnen in herkömmlichen integrierten Schaltungen bislang gänzlich ungenutzt sind, wird die integrierte Schaltung durch die Integration der Kondensatoren nicht oder allenfalls minimal größer als es ohne die Kondensator-Integration der Fall Wäre.

Die erfindungsgemäße integrierte Schaltung kann daher auf einer minimalen Fläche untergebracht werden.

Die Nähe der Kondensatoren zu den die zu glättende Versorgungsspannung leitenden Versorgungsbahnen ermöglicht es darüber hinaus, daß die elektrischen Verbindungen, die erforderlich sind, um die Kondensatoren wirkungsmäßig zwischen den beiden Polen der Versorgungsspannung anzuordnen, äußerst kurz sein können, wodurch die integrierte Schaltung einfach im Aufbau und der Herstellung und zuverlässig im Betrieb ist.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnung näher erläutert. Es zeigen
- Figur 1: schematisch in Schnittansicht den prinzipiellen Aufbau und die bevorzugte Anordnung von zur Glättung der Versorgungsspannung vorgesehenen Kondensatoren innerhalb einer integrierten Schaltung, und
- Figur 2: eine Draufsicht auf eine Kondensatoren gemäß Figur 1 enthaltende integrierte Schaltung.

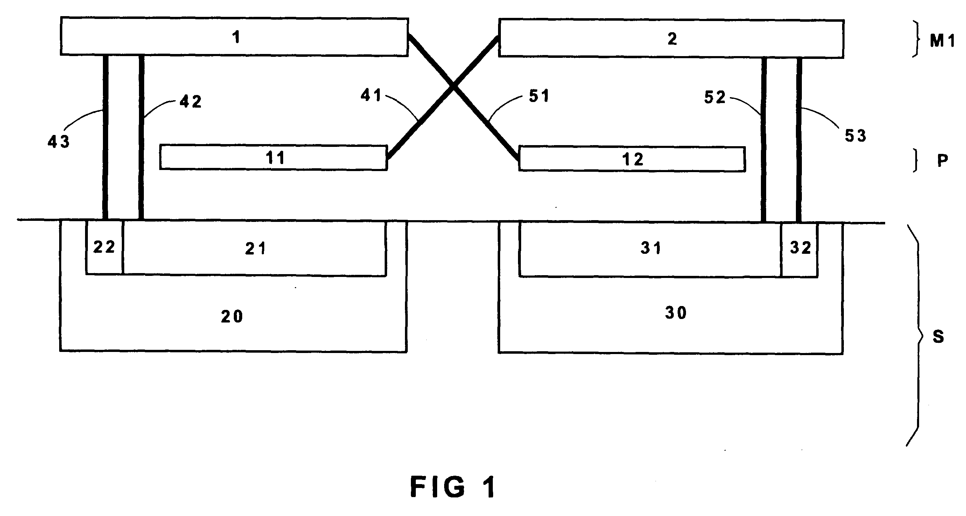

Zu Figur 1 sei vorab angemerkt, daß dort - obgleich es sich um eine Schnittdarstellung handelt - aus Gründen der Übersichtlichkeit keine Schraffuren eingezeichnet sind.

Bei der vorliegend näher betrachteten integrierten Schaltung handelt es sich um eine CMOS-Schaltung, die, wie insbesondere aus Figur 1 ersichtlich ist, ein Substrat S (beispielsweise aus Silizium), eine mit Abstand darüber angeordnete Polysilizium-Schicht (Poly-Schicht bzw. Poly-Layer) P, und eine über dieser mit Abstand angeordnete Metallschicht (Metall-Layer) M1 umfaßt; es ist nicht ausgeschlossen, daß auch noch weitere Schichten, beispielsweise eine Poly2-Schicht, eine Metal2-Schicht etc. vorgesehen sind. Die Zwischenräume zwischen den einzelnen Schichten sind durch ein in den Figuren nicht naher bezeichnetes Isoliermaterial (beispielsweise Siliziumoxid) ausgefüllt.

Die gezeigten Strukturen des Metall-Layer M1 sind eine VDD-Versorgungsbahn 1 und eine VSS-Versorgungsbahn 2, über welche die Versorgungsspannung (im betrachteten Beispiel das VDD-Potential und das VSS-Potential) zu den Stellen geleitet wird, an welchen sie benötigt wird. Wie die Bezeichnungen schon andeuten, wird über die VDD-Versorgungsbahn 1 das VDD-Potential, und über die VSS-Versorgungsbahn 2 das VSS-Potential an die integrierte Schaltung angelegt.

Die VDD-Versorgungsbahn 1 und die VSS-Versorgungsbahn 2 sind über zur Glättung der Versorgungsspannung dienende Kondensatoren miteinander verbunden. Diese Kondensatoren sind, wie noch genauer beschrieben werden wird, unter der VDD-Versorgungsbahn 1 und/oder der VSS-Versorgungsbahn 2 angeordnet und werden durch das Zusammenwirken der Polysilizium-Schicht P und dem Substrat S gebildet.

Gemaß der Darstellung in der Figur 1 sind zwei Kondensatoren vorgesehen, wovon einer unter der VDD-Versorgungsbahn 1 und wovon der andere unter der VSS-Versorgungsbahn 2 eingezeichnet ist.

Der unter der VDD- Versorgungsbahn 1 liegende Kondensator wird durch einen in der Polysilizium-Schicht gebildeten Poly-Abschnitt 11, einen darunter im Substrat S oder einer n-Wanne 20 desselben vorgesehenen p⁺-Bereich 21 und dem dazwischen liegenden Isoliermaterial gebildet; der unter der VSS-Versorgungsbahn 2 liegende Kondensator wird durch einen in der Polysilizium-Schicht gebildeten Poly-Abschnitt 12, einen darunter im Substrat S oder einer p-Wanne 30 desselben vorgesehenen n⁺-Bereich 31 und dem dazwischen liegenden Isoliermaterial gebildet.

Von dem unter der VDD-Versorgungsbahn 1 liegenden Kondensator ist der Poly-Abschnitt 11 über eine Durchkontaktierung 41 mit der VSS-Versorgungsbahn 2 und der p⁺-Bereich 21 über eine Durchkontaktierung 42 mit der VDD-Versorgungsbahn 1 verbunden; der unter der VDD-Versorgungsbahn liegende Kondensator ist wirkungsmäßig also zwischen der VDD-Versorgungsbahn 1 und der VSS-Versorgungsbahn 2 angeordnet.

Von dem unter der VSS-Versorgungsbahn 2 liegenden Kondensator ist der Poly-Abschnitt 12 über eine Durchkontaktierung 51 mit der VDD-Versorgungsbahn 1 und der n⁺-Bereich 31 über eine Durchkontaktierung 52 mit der VSS-Versorgungsbahn 2 verbunden; der unter der VSS-Versorgungsbahn 2 liegende Kondensator ist wirkungsmäßig also ebenfalls zwischen der VDD-Versorgungsbahn 1 und der VSS-Versorgungsbahn 2 angeordnet, wodurch der unter der VDD-Versorgungsbahn 1 liegende Kondensator und der unter der VSS-Versorgungsbahn 2 liegende Kondensator elektrisch parallel zueinander angeordnet sind.

Insbesondere wenn die Kondensatoren eine größere Fläche aufweisen, sollte zwischen dem p⁺-Bereich 21 und der VDD-Versorgungsbahn 1 eine Vielzahl von Durchkontaktierungen 42 und zwischen dem n⁺-Bereich 31 und der VSS-Versorgungsbahn 2 eine Vielzahl von Durchkontaktierungen 52 vorgesehen werden. Dadurch lassen sich die Realteile der Kondensator-Impedanzen niedrig halten, was insbesondere für das Hochfrequenzverhalten der Kondensatoren sehr bedeutsam ist. Es erweist sich als besonders günstig, wenn der ohmsche Widerstand eines jeweiligen Kondensators zu in etwa gleichen Teilen durch den p⁺-Bereich 21 und den Poly-Abschnitt 11 bzw. durch den n⁺-Bereich 31 und den Poly-Abschnitt 12 verursacht werden.

Benachbart zum p⁺-Bereich 21 und - sofern vorhanden - ebenfalls noch innerhalb der n-Wanne 20 ist ein n⁺-Bereich 22 vorgesehen, der über eine Durchkontaktierung 43 mit der VDD-Versorgungsbahn 1 verbunden ist; benachbart zum n⁺-Bereich 31 und - sofern vorhanden - ebenfalls noch innerhalb der p-Wanne 30 ist ein p⁺-Bereich 32 vorgesehen, der über eine Durchkontaktierung 53 mit der VSS-Versorgungsbahn 2 verbunden ist. Die genannten Durchkontaktierungen 43 und 53 sind sogenannte Substratkontakte, deren Funktion und Wirkungsweise bekannt ist und keiner weiteren Erläuterung bedarf. Die Substratkontakte sind im betrachteten Beispiel jedoch "nur" sicherheitshalber zur Vorsorge gegen normalerweise nicht auftretende Umstände und/oder zur Vereinheitlichung der Wannenherstellung vorgesehen; es sind keine, jedenfalls keine ernsthaften Veränderungen der Funktion und Wirkungsweise der jeweiligen Kondensatoren zu erwarten, wenn die Substratkontakte, d.h. der n⁺-Bereich 22 und die Durchkontaktierung 43 sowie der p⁺-Bereich 32 und die Durchkontaktierung 53 weggelassen werden.

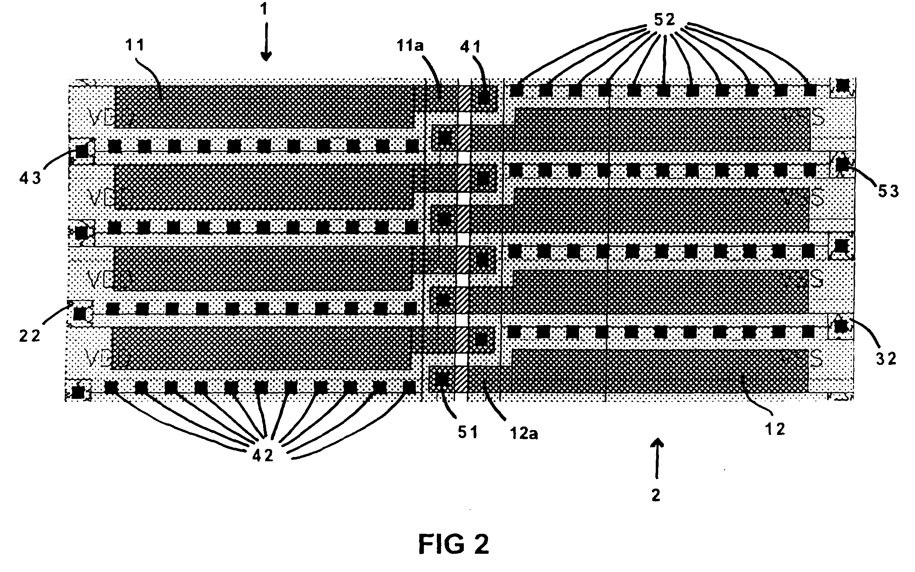

Der Aufbau und die Anordnung der vorstehend beschriebenen Kondensatoren ist, wie vorstehend bereits erwähnt wurde, in der Figur 1 nur stark schematisiert dargestellt. Eine mögliche praktische Realisierung einer solchen Anordnung ist in der Figur 2 gezeigt.

In den Figuren 1 und 2 sind einander entsprechende Elemente mit den gleichen Bezugszeichen bezeichnet.

Wie aus der Figur 2 ersichtlich ist, befinden sich die zur Glättung der Versorgungsspannung vorgesehenen Kondensatoren im wesentlichen vollständig unter den Versorgungsbahnen 1 und 2, welche dort als gepunktete Flächen dargestellt sind.

Die in der Figur 2 als gestrichelte Flächen dargestellten Poly-Abschnitte 11 und 12 sind streifenartig ausgebildet und in großer Anzahl vorgesehen. Die Anzahl der Poly-Abschnitte 11 und 12 entspricht - jedenfalls im betrachteten Beispiel - der Anzahl der vorhandenen Kondensatoren.

Die Poly-Abschnitte 11 sind im wesentlichen vollständig unter der VDD-Versorgungsbahn 1 angeordnet. Jeder der Poly-Abschnitte 11 weist jedoch einen fingerartigen Fortsatz 11a auf, der sich über den Bereich der VDD-Versorgungsbahn 1 hinaus unter die VSS-Versorgungsbahn 2 erstreckt und dort über die als schwarze Fläche dargestellte Durchkontaktierung 41 mit dieser verbunden ist. Ähnliches gilt für die Poly-Abschnitte 12: diese sind im wesentlichen vollständig unter der VSS-Versorgungsbahn 2 angeordnet, wobei jedoch jeder der Poly-Abschnitte 12 einen fingerartigen Fortsatz 12a aufweist, der sich über den Bereich der VSS-Versorgungsbahn 2 hinaus unter die VDD-Versorgungsbahn 1 erstreckt und dort über die Durchkontaktierung 51 mit dieser verbunden ist.

Damit die fingerartigen Fortsätze 11a und 12a ausreichend weit beabstandet aneinander vorbeilaufen können, sind die Poly-Abschnitte 11 und 12 bezüglich ihrer Querrichtung relativ zueinander versetzt angeordnet. Insbesondere wenn die Polyabschnitte 11 und 12 breiter und/oder die fingerartigen Fortsätze 11a und 12a schmäler als in der Figur 2 dargestellt sind, kann auf den gegenseitigen Versatz verzichtet werden.

Der in der Figur 2 nicht eingezeichnete p⁺-Bereich 21, der sich unter jedem Poly-Abschnitt 11 befindet, ist flächenmäßig größer ausgebildet als der betreffende Polyabschnitt 11 und ist durch eine Vielzahl von in einer Reihe angeordneten Durchkontaktierungen 42 mit der VDD-Versorgungsbahn 1 verbunden, wobei sich die Reihe der Durchkontaktierungen jeweils im Zwischenraum zwischen benachbarten Poly-Abschnitten 11 befindet. Es ist nicht erforderlich, daß jedem Poly-Abschnitt 11 ein eigener p⁺-Bereich 21 zugeordnet ist; es kann auch ein einziger großer, für alle Poly-Abschnitte 11 gemeinsamer p⁺-Bereich vorgesehen sein.

Entsprechendes gilt für die unter der VSS-Versorgungsbahn 2 vorgesehnenen Kondensatoren: Der in der Figur 2 nicht eingezeichnete n⁺-Bereich 31, der sich unter jedem Poly-Abschnitt 12 befindet, ist flächenmäßig größer ausgebildet als der betreffende Poly-Abschnitt 12 und ist durch eine Vielzahl von in einer Reihe angeordneten Durchkontaktierungen 52 mit der VSS-Versorgungsbahn 2 verbunden, wobei sich die Reihe der Durchkontaktierungen jeweils im Zwischenraum zwischen benachbarten Poly-Abschnitten 12 befindet. Es ist nicht erforderlich, daß jedem Poly-Abschnitt 12 ein eigener n⁺-Bereich 31 zugeordnet ist; es kann auch ein einziger großer, für alle Poly-Abschnitte 12 gemeinsamer n⁺-Bereich vorgesehen sein.

Pro Kondensator ist ein Substratkontakt vorgesehen, welcher bei den unter der VDD-Versorgungsbahn 1 liegenden Kondensatoren durch die Durchkontaktierung 43, und bei den unter der VSS-Versorgungsbahn 1 liegenden Kondensatoren durch die Durchkontaktierung 53 realisiert ist.

Die bislang nicht praktizierte Anordnung der Kondensatoren unter den Versorgungsbahnen erweist sich in mehrfacher Hinsicht als vorteilhaft: Einerseits weil dieser Platz bisher nicht anderweitig genutzt wurde und die Anordnung der Kondensatoren an dieser Stelle nicht zu einer Vergrößerung der integrierten Schaltung führt, und andererseits weil sich die unumgänglichen Verbindungen zwischen den Versorgungsbahnen und den wo auch immer vorgesehenen Kondensatoren dadurch besonders einfach und elegant herstellen lassen.

Wenngleich die in der Figur 2 dargestellte Topographie derzeit als die einfachste und effizienteste Kondensator-Anordnung angesehen wird, soll dies nicht als Einschränkung der Erfindung verstanden werden. Die Kondensatoren können grundsätzlich auch beliebig anders unter den Versorgungsbahnen angeordnet werden.

Zusammenfassend kann abschließend festgestellt werden, daß die beschriebene integrierte Schaltung auf sehr einfache Art und Weise auf einer minimalen Fläche unterbringbar ist.

## Patentansprüche

1. Integrierte Schaltung mit Kondensatoren zur Glättung der Versorgungsspannung,
**dadurch gekennzeichnet,**
daß die Kondensatoren (11, 21; 12, 31) unterhalb der Versorgungsbahnen (1, 2), über welche die integrierte Schaltung mit der Versorgungsspannung versorgt wird, angeordnet sind.

2. Integrierte Schaltung nach Anspruch 1,
**dadurch gekennzeichnet,**
daß die Versorgungsbahnen (1, 2) eine für das VDD-Potential vorgesehene VDD-Versorgungsbahn (1) und eine für das VSS-Potential vorgesehene VSS-Versorgungsbahn (2) umfassen und Bestandteil einer Metall-Schicht (M1) der integrierten Schaltung sind.

3. Integrierte Schaltung nach Anspruch 2,
**dadurch gekennzeichnet,**
daß sowohl unter der VDD-Versorgungsbahn (1) als auch unter der VSS-Versorgungsbahn (2) ein oder mehrere Kondensatoren (11, 21; 12, 31) vorgesehen sind.

4. Integrierte Schaltung nach Anspruch 2 oder 3,
**dadurch gekennzeichnet,**
daß die Kondensatoren (11, 21; 12, 31) entweder im wesentlichen unter der VDD-Versorgungsbahn (1) oder im wesentlichen unter der VSS-Versorgungsbahn (2) angeordnet sind.

5. Integrierte Schaltung nach Anspruch 4,
**dadurch gekennzeichnet,**
daß die Kondensatoren (11, 21), die im wesentlichen unter der VDD-Versorgungsbahn (1) angeordnet sind, durch ein Zusammenwirken von in einer Polysilizium-Schicht (P) der integrierten Schaltung ausgebildeten Poly-Abschnitten (11) und darunter im Substrat (S) der integrierten Schaltung ausgebildeten p⁺-Bereichen (21) gebildet werden.

6. Integrierte Schaltung nach Anspruch 5,
**dadurch gekennzeichnet,**
daß der Poly-Abschnitt (11) mit der VSS-Versorgungsbahn (2), und der p⁺-Bereich (21) mehrfach mit der VDD-Versorgungsbahn (1) verbunden ist.

7. Integrierte Schaltung nach einem der Ansprüche 4 bis 6,
**dadurch gekennzeichnet,**
daß die Kondensatoren (12, 31), die im wesentlichen unter der VSS-Versorgungsbahn (2) angeordnet sind, durch ein Zusammenwirken von in einer Polysilizium-Schicht (P) der integrierten Schaltung ausgebildeten Poly-Abschnitten (12) und darunter im Substrat (S) der integrierten Schaltung ausgebildeten n⁺-Bereichen (31) gebildet werden.

8. Integrierte Schaltung nach Anspruch 7,
**dadurch gekennzeichnet,**
daß der Poly-Abschnitt (12) mit der VDD-Versorgungsbahn (1), und der n⁺-Bereich (31) mehrfach mit der VSS-Versorgungsbahn (1) verbunden ist.

9. Integrierte Schaltung nach einem der Ansprüche 5 bis 8,
**dadurch gekennzeichnet**,
daß die Poly-Abschnitte (11, 12) streifenartig ausgebildet sind und fingerartige Fortsätze (11a, 12a) aufweisen, welche sich bei den im wesentlichen unter der VDD-Versorgungsbahn (1) angeordneten Kondensatoren (11, 21) bis unter die VSS-Versorgungsbahn (2) und bei den im wesentlichen unter der VSS-Versorgungsbahn (2) angeordneten Kondensatoren (12, 31) bis unter die VDD-Versorgungsbahn (1) erstrecken.

10. Integrierte Schaltung nach einem der Ansprüche 5 bis 9,
**dadurch gekennzeichnet,**
daß die Zwischenräume zwischen benachbarten Poly-Abschnitten (11, 12) für die Verbindung der p⁺-Bereiche (21) mit der VDD-Versorgungsbahn (1) bzw. für die Verbindung der n⁺-Bereiche (31) mit der VSS-Versorgungsbahn (2) genutzt werden.
